# EUROPÄISCHE PATENTANMELDUNG

(11) **EP 0 600 241 A2**
(43) Veröffentlichungstag der Anmeldung: **08.06.1994**
(21) Anmeldenummer: 93117673.9
(22) Anmeldetag: 02.11.1993
(51) Int. Cl.: H01L 29/72

(54) **MOS-gesteuerte Diode**

(30) Priorität: 28.11.1992 DE 4240027
(71) Anmelder: ASEA BROWN BOVERI AG, CH-5401 Baden (CH)
(72) Erfinder: Stockmeier, Thomas, Dr., CH-5405 Baden-Dättwil (CH)
(74) Vertreter: Lück, Gert, Dr.

(57) **Zusammenfassung**

Es wird eine MOS gesteuerte Diode (1) offenbart, welche eine p⁺- (5) und eine n⁻-Schicht (4) sowie eine n⁺-Schicht (9) umfasst. Zwischen der n⁻-Schicht (4) und der n⁺-Schicht (9) ist ein p-Gebiet (8), welches die n⁺-Schicht (9) vollständig umgibt, angeordnet. Mittels Anlegen einer Spannung an einer darüber angeordneten, isolierten Gateelektrode kann das p-Gebiet (8) überbrückt werden. Dadurch geht die Diode vom normal sperrenden Zustand in den leitenden über. Mittels kathodenseitigem Randabschluss kann die Diode hochsperrend gemacht werden. Mit einem anodenseitigen Randabschluss (15) erhält man eine rückwärtssperrende Diode, mit anodenseitigen Kurzschlüssen (14) ein rückwärtsleitende Diode.

## Beschreibung

### Technisches Gebiet

Die Erfindung bezieht sich auf das Gebiet der Leistungselektronik.

Sie geht aus von einer Halbleiterdiode gemäss dem Oberbegriff des ersten Anspruchs.

### Stand der Technik

Ein solche Halbleiterdiode wird beispielsweise schon im Lehrbuch "Bauelemente der Halbleiter-Elektronik" (Springer-Verlag 1979) von R. Müller beschrieben.

Eine solche Diode mit einer p⁺n⁻n⁺ -Struktur wird normalerweise als pin-Diode bezeichnet und findet als Leistungsdiode weit verbreiteten Einsatz.

Bei abschaltbaren Leistungshalbleiterbauelementen nehmen wegen ihrer einfachen Ansteuerbarkeit und aufgrund der einfacheren Schutzbeschaltung MOS-gesteuerte Bauelemente einen immer grösseren Raum in der Leistungselektronik ein und erschliessen in immer stärkeren Masse neue Anwendungen. Solche Bauelemente sind Power-MOSFETs, IGBTs, MCTs.

Während Power-MOSFETs bis zu sehr hohen Schaltfrequenzen (MHz) einsetzbar und einfach zu steuern sind und durch Parallelschaltung auch hohe Ströme (einige 100 A) kontrolliert werden können, ist die maximale Blockierspannung relativ begrenzt (einige 100V). Dieser Umstand verhindert jedoch die Verwendung von solchen Bauelementen im Hochleistungsbereich.

Die Schaltfrequenzen von IGBTs sind zwar gegenüber denjenigen von MOSFETs deutlich reduziert, diese Bauelemente weisen jedoch einen geringeren On-Widerstand und eine deutlich höhere Spannungsfestigkeit (bis ca. 1200 V) auf. Auch diese Art von Bauelementen lässt sich ohne besondere Probleme parallelschalten. Der Einsatz im Hochleistungsbereich ist jedoch durch die noch immer zu geringe Spannungsfestigkeit nicht möglich.

MOS gesteuerte Thyristoren (MCTs) zeichnen sich durch einen geringen On-Widerstand aus und sind auch für höchste Spannungen auslegbar. Jedoch ist die Herstellung grossflächiger Bauelemente (= grosser Strom) und die Parallelschaltung von MCTs bis heute aufgrund der inneren Struktur noch nicht möglich, so dass sich auch hier keine Hochleistungsanwendungen realisieren lassen.

Gemeinsam ist allen MOS-gesteuerten Bauelementen, dass sie relativ feine Strukturen (<= 5µm) aufweisen und daher die Chipfläche bei vernünftiger Chipausbeute auf ca 2 cm² beschränkt bleibt. Ausserdem ist der Herstellaufwand im Vergleich mit bipolaren, abschaltbaren Bauelementen (Transistoren, GTO) relativ hoch.

Problematisch bleibt also trotz der einfachen und verlustarmen Ansteuerung von MOS-gesteuerten Bauelementen die Anwendung im Hochleistungsbereich und die hohen Anforderungen an die Herstellung.

### Darstellung der Erfindung

Aufgabe der vorliegenden Erfindung ist es deshalb, ein neues Bauelement anzugeben, welches für Hochleistungszwecke geeignet und einfach herzustellen ist.

Diese Aufgabe wird bei einer Halbleiterdiode der eingangs genannten Art durch die Gesamtheit Merkmale des ersten Anspruchs gelöst.

Es handelt sich dabei um eine MOS-gesteuerte Diode (MCD). Eine solche MCD zeichnet sich besonders dadurch aus, dass zwischen der n⁻-Schicht und der n⁺-Schicht ein p-Gebiet angeordnet ist und Mittel vorgesehen sind welche die Ueberbrückung dieses p-Gebietes zulassen.

In einem ersten Ausführungsbeispiel umfassen diese Mittel eine isolierte Gateelektrode, welche über dem p-Gebiet angeordnet ist. Durch Anlegen einer positiven Spannung bildet sich im p-Gebiet ein n-Kanal, welcher die n⁻-Schicht und die n⁺-Schicht verbindet.

In einem weiteren Ausführungsbeispiel ist auf der Seite der Kathode zusätzlich ein Randabschluss vorgesehen. Dadurch wird das Bauelement hochsperrend.

Weitere Ausführungsformen ergeben sich aus den Unteransprüchen.

Der Vorteil des erfindungsgemässen Aufbaus besteht darin, dass es sich um ein MOS-gesteuertes Bauteil handelt, welches alle damit verbundenen Vorzüge aufweist, welches aber aufgrund seines einfachen Aufbaus dennoch leicht herzustellen ist und auch sich leicht in Serie bzw. parallel schalten lässt.

### Kurze Beschreibung der Zeichnungen

Nachfolgend wird die Erfindung anhand von Ausführungs-beispielen im Zusammenhang mit den Zeichnungen näher erläutert.

Es zeigen:
- **Fig. 1**: Einen Schnitt durch eine hochsperrenden MOS-gesteuerte Diode;
- **Fig. 2**: Einen Schnitt durch eine rückwärtssperrende MOS-gesteuerte Diode; und
- **Fig. 3**: Einen Schnitt durch eine rückwärtsleitende, MOS-gesteuerte Diode.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

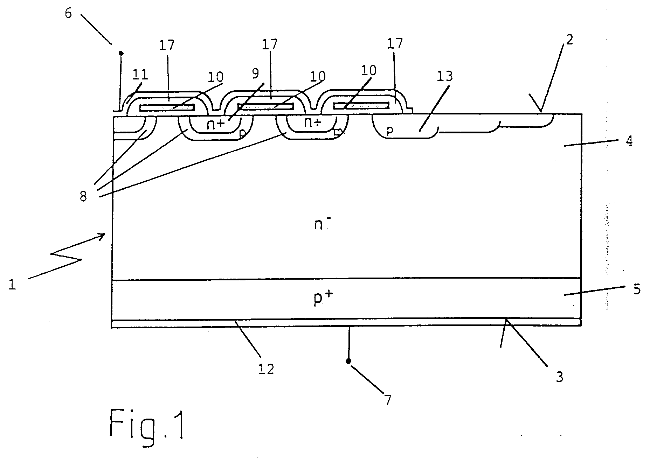

**Figur 1** zeigt einen Schnitt durch eine erfindungsgemässe MOS-gesteuerte Diode oder MCD (1). Eine solche ist aus einem Silizium-Substrat aufgebaut, welches zwischen zwei Hauptflächen (2,3) eine erste n⁻-Ladungsträgerschicht (4) und eine zweite p⁺-Ladungsträgerschicht (5) aufweist.

In der ersten Ladungsträgerschicht (4) sind mehrere wannenförmige p-Gebiete (8) eindiffundiert. Jedes p-Gebiet (8) umschliesst ein ebenfalls wannenförmiges, aber kleineres und n⁺-dotiertes n⁺-Gebiet (9). Das n⁺-Gebiet (9) und das p-Gebiet (8) dringen an die erste Hauptfläche (2). Zwischen den p-Gebieten (8) dringt die n⁻-Ladungsträgerschicht (4) an die erste Hauptfläche (2).

Die p⁺Ladungsträgerschicht (5), die n⁻-Ladungsträgerschicht (4) und das n⁺-Gebiet (9) bilden die bekannte pin-Struktur einer Hochleistungsdiode. Demzufolge stellt die p⁺-Schicht (5) die Anode (7) der MCD (1) dar, während das n⁺-Gebiet die Kathode (6) bildet. Sowohl Anode (7) wie Kathode (6) werden durch eine die p⁺-Schicht (5) bzw. das n⁺-Gebiet (9) kontaktierende Metallschicht (12 bzw. 11) gebildet.

Ueber der ersten Hauptfläche (2) und durch eine Isolationsschicht (17) elektrisch isoliert angeordnet sind mehrere, untereinander verbundene Gateelektroden (16). Diese Gateelektroden (16) werden jeweils durch eine Polysiliziumschicht (10) gebildet. Diese Polysiliziumschicht (10) reicht vom Rand eines n⁺-Gebietes (9), über das zugehörige p-Gebiet (8), über die zwischen zwei benachbarten p-Gebieten (8) liegende n⁻-Schicht (4) und über das benachbarte p-Gebiet (8) bis zum Rand des benachbarten n⁺-Gebiets (9). Die Gate-Isolierung (17) ist mit der Metallisierung (11) der Kathode überzogen.

Nach der Erfindung ist also zwischen der n-Schicht (4) und dem n⁺-Gebiet (9) ein zusätzliches p-Gebiet (8) vorgesehen. Demgemäss blockiert die MCD (1) in Vorwärtsrichtung, d.h. wenn an der Anode eine positive Spannung angelegt wird, während die Kathode auf Masse liegt. Diese Blockierfähigkeit wird durch eine Raumladungszone gewährleistet, welche sich in Vorwärtsspannungsrichtung zwischen dem p-Gebiet (8) und der n⁻-Schicht (4) bildet. Das Bauelement ist also normalerweise ausgeschaltet ("normally off").

Legt man nun an das Gate (16) ein positive Spannung von ca. 5 V an, so bildet sich ein n-leitender Kanal im p-Gebiet (8), welcher Kanal die Kathode (6) bzw. das n⁺-Gebiet (9) mit der n⁻-Schicht (4) verbindet. Aufgrund dieses n-Kanals leitet die MCD (1) nun in Vorwärtsrichtung.

Damit ist ein neues MOS-gesteuertes, ein- und ausschaltbares Bauelement geschaffen, welches sich vor allem durch einen sehr einfachen Aufbau auszeichnet.

Von dieser MCD (1) existieren verschiedene bevorzugte Ausführungsformen, welche in den Figuren 1-3 dargestellt sind.

In Figur 1 ist zusätzlich zur oben erläuterten Struktur ein kathodenseitiger Randabschluss (13) vorgesehen. Der Randabschluss (13) wird durch ein immer schmaler werdendes p-Gebiet gebildet. Dieses p-Gebiet reicht von der äussersten Gate-Polysiliziumschicht (10) bis nicht ganz zum Rand des Bauteils.

Durch einen solchen kathodenseitigen Randabschluss (13) kann die MCD (1) im ausgeschalteten Zustand, d.h. keiner positiven Spannung am Gate, höchste Sperrspannungen aufnehmen.

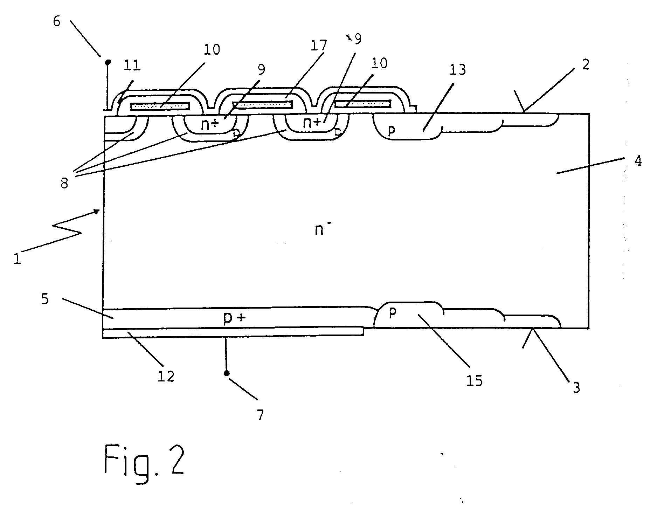

In **Figur 2** ist zusätzlich zur Struktur von Figur 1 ein anodenseitiger Randabschluss (15) vorhanden. Dieser Randabschluss (15) ist analog dem kathodenseitigen Randabschluss (13) aufgebaut. Durch einen solchen anodenseitigen Randabschluss (15) erhält man eine MCD, welche in Rückwärtsrichtung, d.h. Kathode mit pos. Spannung bezgl. der Anode, sperrt.

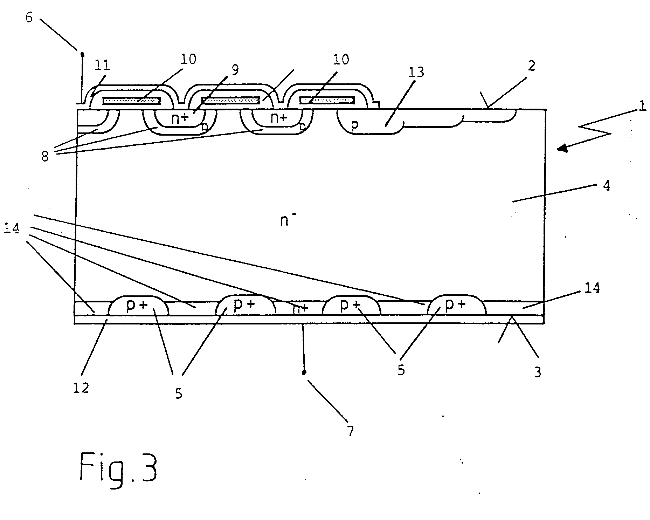

In **Figur 3** sind zusätzlich zur Struktur von Figur 1 anodenseitige Kurzschlüsse (14) vorhanden. Diese Anodenkurzschlüsse werden durch n⁺-Gebiete (14) gebildet, welche die p⁺-Schicht (5) durchdringen. Durch solche anodenseitigen Kurzschlüsse (14) erhält man eine MCD, welche in Rückwärtsrichtung, d.h. Kathode mit pos. Spannung bezgl. der Anode, leitet.

Eine erfindungsgemässe MOS-gesteuerte Diode besteht wie alle anderen MOS gesteuerten Bauelemente (MCT, IGBT, MOSFET) aus einer Vielzahl von solchen parallelgeschalteten Elementarzellen oder -streifen, von welchen in den Figuren 1-3 je 3 dargestellt sind und deren Funktion oben erläutert wurde.

Gegenüber diesen bekannten MOS gesteuerten Bauelementen ergeben sich jedoch folgende, entscheidenden Vorteile:
- Die Struktur ist vollständig selbstjustierend, d.h. es gibt keine funktionsunfähigen Bauelemente aufgrund ungenauer Justierung;
- Zur Herstellung der Bauelementes sind im Prinzip nur 3 Maskenebenen nötigt, nämlich:
   a) Strukturierung des Polysiliziums (Erzeugung der Kathode (6), des Randabschlusses (13) und der Justiermarken),
   b) Strukturierung der Isolationsschicht (17) aus Siliziumoxid zwischen Gate (16) und Kathode (6) (Kontaktlochätzung),
   c) Strukturierung der Kathodenmetallisierung (11).

Zur Realisierung des kathodenseitigen Randabschlusses wird in der Praxis vorteilhafterweise auch eine eigene Maskenebene verwendet. Das gleiche gilt für den anodenseitigen Randabschluss bzw. die anodenseitigen Kurzschlüsse.

Die erfindungsgemässe MOS gesteuerte Diode weist also bezüglich der Einfachheit des Aufbaus eine optimale Struktur auf. Sie kann auch problemlos parallel- bzw. in Serie geschaltet werden.

### Bezeichnungsliste

- 1: MCD
- 2: erste Hauptfläche
- 3: zweite Hauptfläche
- 4: erste Ladungsträgerschicht (n⁻)
- 5: zweite Ladungsträgerschicht (p⁺)
- 6: Kathode
- 7: Anode
- 8: p-Gebiet
- 9: n⁺-Gebiet
- 10: Gate-Polysiliziumschicht
- 11: Kathoden-Metallisierung
- 12: Anoden-Metallisierung
- 13: Kathodenseitiger Randabschluss
- 14: Anodenkurzschlüsse
- 15: Anodenseitiger Randabschluss
- 16: Gateelektrode
- 17: Gate-Isolierung

## Patentansprüche

1. Halbleiterdiode mit
a) einem zwischen zwei Hauptflächen (2, 3) angeordneten und aus einer ersten n⁻-Ladungsträgerschicht (4) und einer zweiten p⁺-Ladungsträgerschicht (5) gebildeten pn-Uebergang;
b) einem zwischen einer Kathodenmetallisierung (11) und der ersten n⁻-Ladungsträgerschicht (4) angeordnetem n⁺-Gebiet (9), welches mit der Kathodenmetallisierung (11) in elektrischem Kontakt steht; sowie
c) einer Anodenmetallisierung (12) welche auf der zweiten Hauptfläche (3) angeordnet ist und mit der zweiten Ladungsträgerschicht (5) in elektrischer Verbindung steht;
dadurch gekennzeichnet, dass
d) zwischen dem n⁺-Gebiet (9) und der n⁻-Ladungsträgerschicht (4) ein p-Gebiet (8) angeordnet ist, und
e) auf der ersten Hauptfläche (2) Mittel vorgesehen sind, welche das p-Gebiet (8) über einen n-leitenden Kanal kurzschliessen, wobei der Kanal das n⁺-Gebiet (9) mit der n⁻-Ladungsträgerschicht (4) verbindet.

2. Halbleiterdiode nach Anspruch 1, dadurch gekennzeichnet, dass die Mittel eine Gateelektrode (16) umfassen, welche aus einer von der ersten Hauptfläche (2) isolierten Polysiliziumschicht (10) besteht, wobei die Polysiliziumschicht (10) jeweils vom Rand eines n⁺-Gebietes (9) über das zugehörige p-Gebiet (8) und den dazwischen liegenden Bereich der ersten Ladungsträgerschicht (4) bis zum Rand des danebenliegenden n⁺-Gebiets (9) reicht.

3. Halbleiterdiode nach Anspruch 2, dadurch gekennzeichnet, dass das p-Gebiet (8) als in die erste Ladungsträgerschicht (4) eingelassene Wanne ausgebildet ist, welche das n⁺-Gebiet (9) vollständig umfasst.

4. Halbleiterdiode nach einem der vorangehenden Ansprüche, dadurch gekennzeichnet, dass die erste Ladungsträgerschicht (4) auf der Seite der Kathode einen p-dotierten Randabschluss (13), welcher an die erste Hauptfläche (2) dringt, aufweist.

5. Halbleiterdiode nach einem der vorangehenden Ansprüche, dadurch gekennzeichnet, dass die erste Ladungsträgerschicht (5) auf der Seite der Anode einen p-dotierten Randabschluss (15), welcher an die zweite Hauptfläche (3) dringt, aufweist.

6. Halbleiterdiode nach einem der Ansprüche 1-4, dadurch gekennzeichnet, dass die zweite Ladungsträgerschicht (5) mit mehreren n⁺-Gebieten (14), welche Anodenkurzschlüsse bilden, durchsetzt ist.

7. Halbleiterdiode nach einem der vorangehenden Ansprüche, dadurch gekennzeichnet, dass ein Vielzahl von p- und n⁺-Gebieten (8 bzw. 9) vorhanden ist, und die darüber angeordneten Gateelektroden (16) untereinander verbunden sind.
